# EUROPÄISCHE PATENTSCHRIFT

(11) **EP 3 844 030 B1**
(45) Veröffentlichungstag und Bekanntmachung des Hinweises auf die Patenterteilung: **09.10.2024**
(21) Anmeldenummer: 19755837.2
(22) Anmeldetag: 05.08.2019
(51) Int. Cl.: B60R 16/023, H05K 7/20

(54) **KÜHLVORRICHTUNG FÜR BAUTEILE IN EINEM FAHRZEUG**
COOLING DEVICE FOR COMPONENTS IN A VEHICLE
DISPOSITIF DE REFROIDISSEMENT POUR DES PIÈCES DANS UN VÉHICULE

(30) Priorität: 28.08.2018 DE 102018214539
(43) Veröffentlichungstag der Anmeldung: 07.07.2021
(73) Patentinhaber: Continental Automotive Technologies GmbH, 30175 Hannover (DE)
(72) Erfinder: HILLENMAYER, Franz, 81737 München (DE)
(74) Vertreter: Continental Corporation
(86) Internationale Anmeldenummer: PCT/EP2019/070983
(87) Internationale Veröffentlichungsnummer: WO 2020/043432

(56) Entgegenhaltungen:
- EP-A1- 0 841 843
- EP-A2- 1 592 063
- GB-A- 2 343 161
- JP-A- H 098 486
- US-A1- 2002 189 874
- US-A1- 2003 227 732
- US-A1- 2013 155 616

## Beschreibung

Die Erfindung betrifft eine Kühlvorrichtung zur Kühlung eines Bauteils eines Fahrzeugs, insbesondere eines Landfahrzeugs. Weiterhin betrifft die Erfindung ein Fahrzeug und eine Verwendung.

US 2002/189874 A1, EP 1 592 063 A2 betreffen Kühlvorrichtungen.

Die Kühlung von bestimmten Bauteilen, z.B. Elektronikbauteilen, eines Fahrzeugs kann erforderlich sein, um sowohl akute Schäden durch Überhitzung zu vermeiden, als auch, um die Lebensdauer der Bauteile nicht wegen erhöhter thermischer Belastung zu verkürzen. Dies betrifft auch z.B. Bauteile eines Hochleistungsrechners, sowohl in einem Fahrzeug als auch für stationäre Systeme. Einige dieser Kühlvorrichtungen sind aufwändig herzustellen; manche können keine geringere Temperatur zur Verfügung stellen als die Temperatur der Umgebung.

Es ist Aufgabe der Erfindung, eine verbesserte Kühlvorrichtung anzugeben.

Diese Aufgabe wird durch den Gegenstand der unabhängigen Patentansprüche gelöst. Weiterbildungen der Erfindung ergeben sich aus den Unteransprüchen und der folgenden Beschreibung.

Gemäß einem ersten Aspekt der Erfindung ist eine Kühlvorrichtung zur Kühlung eines Bauteils eines Fahrzeugs angegeben, die eine erste, wärmeleitfähige Platte aufweist, die dem Bauteil benachbart ist. Derartige Bauteile können beispielsweise Elektronikbauteile oder Elektronikkomponenten wie Steuerungsrechner, Dachantennen, Frontkameras und eine Vielzahl weiterer Module oder Komponenten sein. Es kann ein einzelnes Bauteil oder mehrere Bauteile der ersten Platte benachbart sein. Das Bauteil und die erste, wärmeleitfähige Platte sind in einer solchen Weise benachbart, dass Wärmeenergie zwischen dem Bauteil und der Platte ausgetauscht werden kann. Insbesondere kann ein geringer thermischer Widerstand zwischen diesen Elementen vorgesehen sein. Da die Platte wärmeleitfähig ist, kann die Wärmeenergie über die Platte weitergegeben werden. In einer Ausführungsform kann der Übergangswiderstand zwischen dem Bauteil und der Platte durch bestimmte Maßnahmen, z.B. durch eine Wärmeleitpaste, reduziert sein.

Bei dem Fahrzeug handelt es sich beispielsweise um ein Kraftfahrzeug, wie Auto, Bus oder Lastkraftwagen, oder aber auch um ein Schienenfahrzeug, ein Schiff, ein Luftfahrzeug, wie Helikopter oder Flugzeug.

Die Kühlvorrichtung weist weiterhin eine zweite Platte auf, die im Wesentlichen parallel zu der ersten Platte angeordnet ist. Die zweite Platte kann ebenfalls wärmeleitfähig sein. Die zweite Platte kann auch aus einem Teil des Fahrzeugs bestehen, z.B. aus einen Abschnitt eines Fahrzeugdachs.

Die zweite Platte kann in einer Ausführungsform wärmeisolierend sein. Dies kann dann sinnvoll sein, wenn die zweite Platte in der Nähe eines heißen Teils des Fahrzeugs, z.B. in der Nähe des Motors angeordnet ist. Es ist auch nicht erforderlich, dass die zweite Platte exakt parallel zu der ersten Platte angeordnet ist; vielmehr soll durch diese Anordnung eine gute Ableitung des Fluids, das zur Kühlung geeignet ist, gewährleistet sein. Es können auch Kanäle gebildet werden, oder die Ableitung des Fluids kann mittels Leitblechen gesteuert werden.

Ferner weist die Kühlvorrichtung einen Diffusor auf, der zwischen der ersten Platte und der zweiten Platte angeordnet ist. Der Diffusor ist zum einen durchlässig für das Fluid, insbesondere in mehreren Richtungen durchlässig. Zum andern setzt es dem Fluid einen vordefinierten Widerstand entgegen.

Die Kühlvorrichtung weist außerdem eine Fluidzuführung auf, die eingerichtet ist, an einem ersten Ende mit einer Fluidquelle verbunden zu werden, und die an einem zweiten Ende mit dem Diffusor in einer solchen Weise verbunden ist, dass ein Fluid von der Fluidquelle von innen nach außen durch den Diffusor strömen kann. Die Fluidquelle, die an dem ersten Ende der Fluidzuführung angeordnet ist, liefert eine Fluidströmung. Die Fluidzuführung ist an dem zweiten Ende mit dem Diffusor verbunden, beispielsweise mit der Mitte des Diffusors. Weil der Diffusor dem Fluid einen vordefinierten Widerstand entgegensetzt, entsteht an dem zweiten Ende der Fluidzuführung ein Überdruck. Durch den Diffusor wird das Fluid gewissermaßen zwangsweise expandiert und das Fluid dadurch abgekühlt (Joule-Thomson-Effekt). Die Kühlvorrichtung stellt daher eine geringere Temperatur zur Verfügung als die Temperatur der Umgebung. Durch die im Wesentlichen parallele Anordnung von der ersten Platte und der zweiten Platte strömt das Fluid über die erste, wärmeleitfähige Platte und sorgt damit für die Verteilung der Wärmeenergie, weg von der ersten Platte und damit dem Bauteil, das der ersten Platte benachbart ist. Gerade die Kombination von Fluidexpansion und Strömung sorgt für eine effiziente Kühlung von Bauteilen.

Erfindungsgemäß weist der Diffusor einen mittig angeordneten Hohlraum auf, an welchen die Fluidzuführung angeschlossen ist. Der mittig angeordnete Hohlraum ist nicht notwendigerweise koaxial zu den Rändern des Diffusors angeordnet; der Hohlraum kann in einer Ausführungsform auch exzentrisch angeordnet sein. Der Hohlraum kann als durchgängige Passage ausgebildet sein, er kann als Sackloch oder als Höhlung ausgebildet sein. Der Vorteil eines Hohlraums besteht darin, dass sich damit die Diffusionsrichtungen des Fluids besser bestimmen lassen als das bei einer einfachen Einleitung der Fluidzuführung in den Diffusor der Fall ist. Darüber hinaus können in einer Ausführungsform die Wandungen des Hohlraums zur weiteren Festlegung der Diffusionseigenschaften bearbeitet sein, z.B. eine bestimmte Oberflächengestaltung, etwa eine Riffelung, aufweisen oder, zumindest teilweise, mit bestimmten Materialen, z.B. Gold, veredelt, um beispielsweise die Korrosionsfestigkeit und/oder die Wärmeleitung weiter zu verbessern.

In einer Ausführungsform weist die Fluidzuführung eine Passage auf, welche durch die zweite Platte zu dem Diffusor führt und die an einem ersten Ende an den Diffusor und an einem zweiten Ende über eine Leitung mit der Fluidquelle verbunden ist. Damit wird das Fluid durch die Passage in der zweiten Platte zugeführt. Dies eignet sich besonders für Ausführungen, bei denen die Kühlvorrichtung sehr gut seitlich zugänglich ist.

In einer Ausführungsform weist die Fluidzuführung eine Leitung auf, welche direkt an den Diffusor angeschlossen ist. Die Leitung verläuft also, zumindest teilweise, durch die Beabstandung zwischen der ersten und der zweiten Platte, welche auch zur Ableitung eines Fluids dient.

In einer Ausführungsform ist der Diffusor mit mindestens einer der Platten form-, kraft- und/oder stoffschlüssig verbunden. Dabei kann der Diffusor zumindest an eine der Platten geklebt, geschweißt, gelötet, geschraubt, genietet sein oder auch zwischen die Platten eingeklemmt. Die Verbindung zur ersten Platte kann wärmeleitfähig sein, z.B. mittels Wärmeleitkleber. In einer Ausführungsform kann der Diffusor mit der ersten Platte als einstückiges Element gestaltet sein. In einer Ausführungsform sind der Diffusor und die erste Platte als einstückiges Element ausgestaltet, wobei in dem Element ein Übergang, insbesondere ein nahtloser Übergang, zwischen dem Material des Diffusors und dem Material der ersten Platte realisiert ist. Diese Ausführungsform hat den Vorteil, dass diese besonders kostengünstig realisiert werden kann; außerdem weist die Ausführungsform besonders gute Wärmeleiteigenschaften auf. In einer Ausführungsform ist die erste Platte als Heat-Pipe ausgeführt. Dies verbessert den Wärmetransport der Heat-Pipe weiter.

wobei der Diffusor (40) mit mindestens einer der Platten (20, 30) form-, kraft- und/oder stoffschlüssig verbunden ist oder der Diffusor (40) und die erste Platte (20) als einstückiges Element ausgestaltet sind, wobei in dem Element ein Übergang, insbesondere ein nahtloser Übergang, zwischen dem Material des Diffusors (40) und dem Material der ersten Platte (20) realisiert ist.

In einer Ausführungsform ist der Diffusor ein Sinterfilter. Der Diffusor kann eine Vielzahl von dünnen Stegen, etwa in Form einer Bürste, oder von Zylindern, oder auch ein Labyrinth aufweisen. Die Stege bzw. Zylinder können Durchmesser von kleiner 100 µm, insbesondere von kleiner 10 µm, aufweisen.

In einer Ausführungsform ist die Fluidquelle ein Kompressor, insbesondere ein Sitz-Kompressor. Ein Sitz-Kompressor hat den Vorteil, dass dieser bereits für die Verwendung in Fahrzeugen ausgelegt ist, z.B. hinsichtlich Betriebsspannung oder Temperaturbereich.

In einer Ausführungsform ist die Fluidquelle in einem kühleren Teil des Fahrzeugs als das Bauteil angeordnet. Die Fluidquelle kann beispielsweise näher am Boden oder im Bereich der Zwangsentlüftung des Fahrzeugs angeordnet sein. Die Platzierung des Bauteils ist dagegen oftmals durch seine Funktionalität vorbestimmt; so wird beispielsweise ein Motorsteuergerät in der Nähe des (heißen) Motors platziert sein, oder eine Dachantenne ist im Bereich des (potentiell heißen) Fahrzeugdachs platziert.

In einer Ausführungsform weist die Fluidquelle einen Überdruck zwischen 0,05 und 1,0 bar, insbesondere zwischen 0,1 und 0,3 bar, auf. Ein Überdruck in diesem Bereich ist technisch recht einfach und kostengünstig beherrschbar, und es können Standardleitungen verwendet werden.

In einer Ausführungsform ist das Fluid ein Gas, insbesondere Luft. Für spezielle Verwendungen können auch andere Gase oder auch Flüssigkeiten verwendet werden.

In einer Ausführungsform weist die erste Platte eine Wärmeleitfähigkeit von größer 50 W / (m · K), insbesondere von größer 200 W / (m · K), auf. Eine Wärmeleitfähigkeit in diesem Bereich unterstützt die Kühlung auf effiziente Weise. Materialien können z.B. Aluminium, Aluminium-Legierungen oder Kupfer sein. Die erste Platte kann auch eine Platine für Elektronikbaugruppen sein, die besonders wärmeleitfähig gestaltet ist; dies kann z.B. mittels Feldern von Vias (Durchkontaktierungen) realisiert sein.

In einer Ausführungsform sind zwischen dem Bauteil und der ersten Platte thermische Interface-Materialien angeordnet. Diese Materialien werden auch als "Thermal Interface Material" (TIM) bezeichnet. Die Materialien umfassen z.B. Wärmeleitpasten, wärmeleitfähige Kleber oder bestimmte Sorten von Silizium-Pads.

Ein weiterer Aspekt der Erfindung betrifft eine Verwendung einer Kühlvorrichtung wie oben und im Folgenden beschrieben zur Kühlung einer Automobilelektronik, von Kameramodulen, z.B. im Bereich der Frontscheibe von Fahrzeugen, oder von Rechnern, insbesondere von Hochleistungsrechnern.

Gemäß einem weiteren Aspekt der Erfindung ist ein Fahrzeug mit einer oben beschriebenen Kühlvorrichtung angegeben.

Zur weiteren Verdeutlichung wird die Erfindung anhand von in den Figuren abgebildeten Ausführungsformen beschrieben. Diese Ausführungsformen sind nur als Beispiel, nicht aber als Einschränkung zu verstehen.
Fig. 1 zeigt schematisch ein Fahrzeug mit einer Kühlvorrichtung;
Fig. 2 zeigt schematisch eine erste Ausführungsform einer Kühlvorrichtung;
Fig. 3 zeigt schematisch eine zweite Ausführungsform einer Kühlvorrichtung.

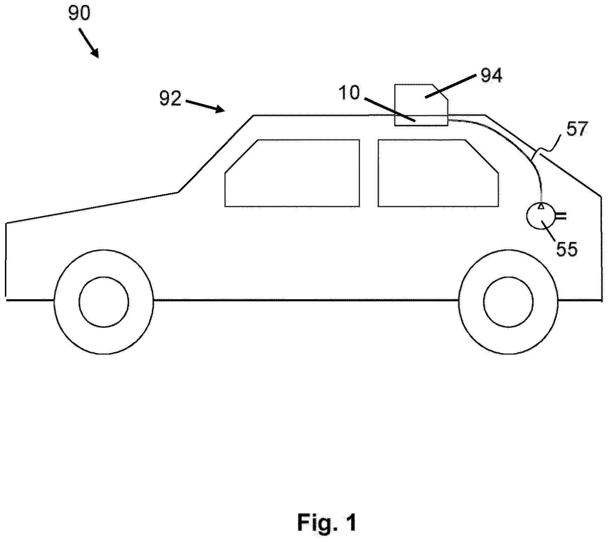

Fig. 1 zeigt ein Fahrzeug 90, in dessen Dachbereich 92 eine Kühlvorrichtung 10 angeordnet ist. Die Kühlvorrichtung 10 kann beispielsweise zur Kühlung einer Autoantenne 94 eingesetzt werden. Dabei ist die Autoantenne 94 oberhalb des Dachs angeordnet, die Kühlvorrichtung 10 unterhalb des Dachs. Im Bereich des Hecks des Fahrzeugs 90 ist ein Kompressor 55 angeordnet, der als Fluidquelle 55 für die Kühlvorrichtung 10 dient. Die Anordnung des Kompressors 55 an dieser Stelle kann dadurch motiviert sein, dass an dieser Stelle die Temperatur in vielen Fällen niedriger sein kann als in dem Dachbereich 92. In anderen Ausführungsformen - oder zur Kühlung anderer Bauteile - kann der Kompressor 55 auch nahe an der Kühlvorrichtung 10 angeordnet sein. Der Kompressor 55 ist mit der Kühlvorrichtung 10 über eine Leitung 57 verbunden. Da der Druck, den der Kompressor 55 erzeugt, relativ niedrig ist, sind die Anforderungen an die Druckbeständigkeit der Leitung 57 recht gering.

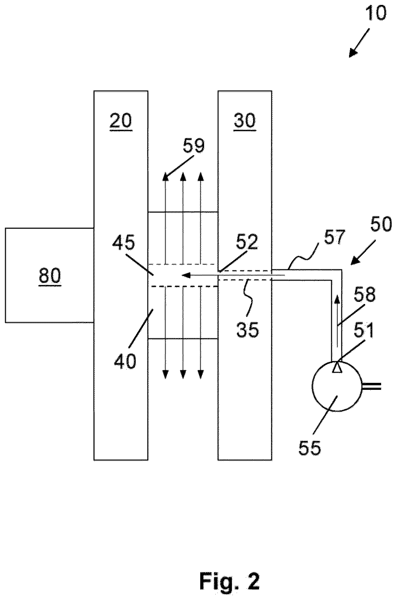

Bei der Ausführungsform von Fig. 2 wird ein Bauteil 80 mittels der Kühlvorrichtung 10 gekühlt. Benachbart zu dem Bauteil 80 ist eine erste, wärmeleitfähige Platte 20 angeordnet, so dass Wärmeenergie zwischen dem Bauteil und der Platte ausgetauscht werden kann. Die wärmeleitfähige Platte 20 kann die Wärmeenergie weitergeben, sowohl innerhalb der Platte 20 als auch durch die Platte 20 hindurch. Benachbart zu der ersten Platte 20 ist ein Diffusor 40 und, daran anschließend, ist eine zweite Platte 30 angeordnet. Bei einer Ausführungsform, wie sie in Fig. 1 skizziert ist, kann die zweite Platte 30 auch durch einen Teil des Dachbereichs 92 des Fahrzeugs 90 oder durch einen Teil einer Autoantenne 94 gebildet sein.

Bei der gezeigten Ausführungsform wird eine Fluidquelle 55 für die Kühlvorrichtung 10 eingesetzt. An die Fluidquelle 55 ist eine Fluidzuführung 50 angeschlossen. Bei diesem Ausführungsbeispiel besteht die Fluidzuführung 50 aus einer Leitung 57, die mit einem ersten Ende 51 an die Fluidquelle 55 angeschlossen ist. Die Fluidzuführung 50 weist weiterhin eine Passage 35 auf, die mit der Leitung 57 verbunden ist. Die Passage 35 führt durch die zweite Platte 30 zu dem Diffusor 40 und bildet, am Ende der Passage 35, das zweite Ende 52 der Fluidzuführung 50. Das Fluid strömt also von der Fluidquelle 55 in Richtung des Pfeils 58 durch die Leitung 57 und durch die Passage 35 in den Hohlraum 45 des Diffusors 40. Vom dem Hohlraum 45 strömt das Fluid in den Raum, der durch die Platten 20 und 30 gebildet wird. Die Pfeile 59 zeigen die Strömungsrichtung des Fluids. Das Fluid strömt dabei über die erste Platte 20 und verbessert dadurch die Kühlung des Bauteils 80.

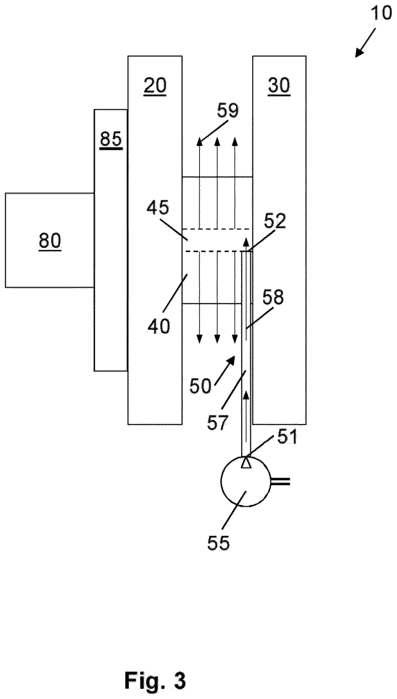

Fig. 3 zeigt schematisch eine zweite Ausführungsform einer Kühlvorrichtung 10. Dabei sind zwischen dem Bauteil 80 und der ersten Platte 20 thermische Interface-Materialien 85 angeordnet, um den thermischen Übergangswiderstand zwischen dem Bauteil 80 und der Platte 20 weiter zu reduzieren. Zwischen den Platten 20 und 30 ist ein Diffusor 40 angeordnet. Der Diffusor 40 ist über eine Leitung 57 mit der Fluidquelle 55 verbunden. Die Fluidzuführung 50 besteht in diesem Beispiel nur aus der Leitung 57. Das Fluid strömt von der Fluidquelle 55 über das erste Ende 51 in Richtung des Pfeils 58 zu dem zweiten Ende 52 und in den Hohlraum 45 des Diffusors 40. Von dem Hohlraum 45 strömt das Fluid in den Raum, der durch die Platten 20 und 30 gebildet wird und in dem auch die Leitung 57 angeordnet ist. Die Pfeile 59 zeigen die Strömungsrichtung des Fluids.

### Bezugszeichenliste

- 10: Kühlvorrichtung
- 20: erste, wärmeleitfähige Platte
- 30: zweite Platte
- 35: Passage
- 40: Diffusor
- 45: Hohlraum
- 50: Fluidzuführung
- 51, 52: erstes bzw. zweites Ende der Fluidzuführung
- 55: Fluidquelle, Kompressor
- 57: Leitung
- 58: Pfeil (Strömungsrichtung in der Leitung)
- 59: Pfeile (Strömungsrichtung aus dem Diffusor)
- 80: Bauteil
- 85: thermische Interface-Materialien
- 90: Fahrzeug
- 92, 94: Dachbereich bzw. Autoantenne des Fahrzeugs

## Patentansprüche

1. Kühlvorrichtung (10) zur Kühlung eines Bauteils (80) eines Fahrzeugs (90), aufweisend:
eine erste, wärmeleitfähige Platte (20), die dem Bauteil (80) benachbart ist,
eine zweite Platte (30), die im Wesentlichen parallel zu der ersten Platte (20) angeordnet ist,
einen Diffusor (40), der zwischen der ersten Platte (20) und der zweiten Platte (30) angeordnet ist, und
eine Fluidzuführung (50), die eingerichtet ist, an einem ersten Ende (51) mit einer Fluidquelle (55) verbunden zu werden, und die an einem zweiten Ende (52) mit dem Diffusor (40) in einer solchen Weise verbunden ist, dass ein Fluid von der Fluidquelle (55) von innen nach außen durch den Diffusor (40) strömen kann,
wobei der Diffusor (40) einen mittig angeordneten Hohlraum (45) aufweist, an welchen die Fluidzuführung (50) angeschlossen ist.

2. Kühlvorrichtung (10) nach Anspruch 1,
wobei die Fluidzuführung (50) eine Passage (35) aufweist, welche durch die zweite Platte (30) zu dem Diffusor (40) führt und die an einem ersten Ende an den Diffusor (40) und an einem zweiten Ende über eine Leitung (57) mit der Fluidquelle (55) verbunden ist.

3. Kühlvorrichtung (10) nach Anspruch 1 oder 2,
wobei die Fluidzuführung (50) eine Leitung (57) aufweist, welche direkt an den Diffusor (40) angeschlossen ist.

4. Kühlvorrichtung (10) nach einem der vorhergehenden Ansprüche,
wobei der Diffusor (40) mit mindestens einer der Platten (20, 30) form-, kraft- und/oder stoffschlüssig verbunden ist oder
der Diffusor (40) und die erste Platte (20) als einstückiges Element ausgestaltet sind, wobei in dem Element ein Übergang, insbesondere ein nahtloser Übergang, zwischen dem Material des Diffusors (40) und dem Material der ersten Platte (20) realisiert ist.

5. Kühlvorrichtung (10) nach einem der vorhergehenden Ansprüche,
wobei der Diffusor (40) ein Sinterfilter ist, eine Vielzahl von dünnen Stegen oder ein Labyrinth aufweist.

6. Kühlvorrichtung (10) nach einem der vorhergehenden Ansprüche,
wobei die Fluidquelle (55) ein Kompressor, insbesondere ein Sitz-Kompressor, ist.

7. Kühlvorrichtung (10) nach einem der vorhergehenden Ansprüche,
wobei die Fluidquelle (55) in einem kühleren Teil des Fahrzeugs als das Bauteil (80) angeordnet ist.

8. Kühlvorrichtung (10) nach einem der vorhergehenden Ansprüche,
wobei die Fluidquelle (55) einen Überdruck zwischen 0,05 und 1,0 bar, insbesondere zwischen 0,1 und 0,3 bar, aufweist.

9. Kühlvorrichtung (10) nach einem der vorhergehenden Ansprüche,
wobei das Fluid ein Gas, insbesondere Luft, ist.

10. Kühlvorrichtung (10) nach einem der vorhergehenden Ansprüche,
wobei die erste Platte (20) eine Wärmeleitfähigkeit von größer 50 W / (m · K), insbesondere von größer 200 W / (m · K), aufweist.

11. Kühlvorrichtung (10) nach einem der vorhergehenden Ansprüche,
wobei zwischen dem Bauteil (80) und der ersten Platte (20) thermische Interface-Materialien angeordnet sind.

12. Verwendung einer Kühlvorrichtung (10) nach einem der Ansprüche 1 bis 10 zur Kühlung einer Automobilelektronik, von Kameramodulen, z.B. im Bereich der Frontscheibe, oder von Rechnern, insbesondere Hochleistungsrechnern.

13. Fahrzeug mit einer Kühlvorrichtung (10) nach einem der Ansprüche 1 bis 10.

## Claims

1. Cooling device (10) for cooling a component (80) of a vehicle (90), having:
a first, heat-conductive plate (20), which is adjacent to the component (80),
a second plate (30), which is arranged substantially parallel to the first plate (20),
a diffuser (40), which is arranged between the first plate (20) and the second plate (30), and
a fluid feed (50), which is designed to be connected at a first end (51) to a fluid source (55), and which is connected at a second end (52) to the diffuser (40) in such a way that a fluid from the fluid source (55) can flow from the inside to the outside through the diffuser (40),
wherein the diffuser (40) has a centrally arranged cavity (45), to which the fluid feed (50) is connected.

2. Cooling device (10) according to Claim 1,
wherein the fluid feed (50) has a passage (35), which leads through the second plate (30) to the diffuser (40) and which is connected at a first end to the diffuser (40) and at a second end via a line (57) to the fluid source (55).

3. Cooling device (10) according to Claim 1 or 2,
wherein the fluid feed (50) has a line (57), which is connected directly to the diffuser (40).

4. Cooling device (10) according to one of the preceding claims,
wherein the diffuser (40) is connected to at least one of the plates (20, 30) in a form-fitting, force-fitting and/or material-bonding manner or the diffuser (40) and the first plate (20) are designed as a one-piece element, wherein a transition, in particular a seamless transition, between the material of the diffuser (40) and the material of the first plate (20) is realized in the element.

5. Cooling device (10) according to one of the preceding claims,
wherein the diffuser (40) is a sintered filter, has a multiplicity of thin fins or a labyrinth.

6. Cooling device (10) according to one of the preceding claims,
wherein the fluid source (55) is a compressor, in particular a seat compressor.

7. Cooling device (10) according to one of the preceding claims,
wherein the fluid source (55) is arranged in a cooler part of the vehicle than the component (80).

8. Cooling device (10) according to one of the preceding claims,
wherein the fluid source (55) has a positive pressure between 0.05 and 1.0 bar, in particular between 0.1 and 0.3 bar.

9. Cooling device (10) according to one of the preceding claims,
wherein the fluid is a gas, in particular air.

10. Cooling device (10) according to one of the preceding claims,
wherein the first plate (20) has a thermal conductivity of greater than 50 W / (m . K), in particular of greater than 200 W / (m · K).

11. Cooling device (10) according to one of the preceding claims,
wherein thermal interface materials are arranged between the component (80) and the first plate (20).

12. Use of a cooling device (10) according to one of Claims 1 to 10 for cooling automobile electronics, camera modules, for example in the area of the front windscreen, or computers, in particular high-performance computers.

13. Vehicle with a cooling device (10) according to one of Claims 1 to 10.

## Revendications

1. Dispositif de refroidissement (10) permettant de refroidir un composant (80) d'un véhicule (90), présentant :
une première plaque thermoconductrice (20) adjacente au composant (80),
une deuxième plaque (30) qui est disposée substantiellement en parallèle à la première plaque (20),
un diffuseur (40) qui est disposé entre la première plaque (20) et la deuxième plaque (30), et
une conduite d'amenée de fluide (50) qui est conçue pour être reliée à une première extrémité (51) à une source de fluide (55), et qui est reliée à une deuxième extrémité (52) au diffuseur (40) de telle sorte qu'un fluide peut s'écouler de la source de fluide (55) de l'intérieur vers l'extérieur à travers le diffuseur (40),
le diffuseur (40) présentant une cavité (45) disposée au centre et à laquelle est raccordée la conduite d'amenée de fluide (50).

2. Dispositif de refroidissement (10) selon la revendication 1,
dans lequel la conduite d'amenée de fluide (50) présente un passage (35) qui mène à travers la deuxième plaque (30) au diffuseur (40) et qui est relié au diffuseur (40) au niveau d'une première extrémité, et est relié à la source de fluide (55) par l'intermédiaire d'une conduite (57) au niveau d'une deuxième extrémité.

3. Dispositif de refroidissement (10) selon la revendication 1 ou 2,
dans lequel la conduite d'amenée de fluide (50) présente une conduite (57) qui est raccordée directement au diffuseur (40).

4. Dispositif de refroidissement (10) selon l'une quelconque des revendications précédentes,
dans lequel le diffuseur (40) est relié à au moins l'une des plaques (20, 30) par complémentarité de forme, par adhérence et/ou par liaison de matière, ou le diffuseur (40) et la première plaque (20) sont réalisés sous la forme d'un élément monobloc, dans lequel une transition, en particulier une transition continue, est réalisée dans l'élément entre le matériau du diffuseur (40) et le matériau de la première plaque (20).

5. Dispositif de refroidissement (10) selon l'une quelconque des revendications précédentes,
dans lequel le diffuseur (40) est un filtre fritté qui présente une pluralité d'entretoises fines ou un labyrinthe.

6. Dispositif de refroidissement (10) selon l'une quelconque des revendications précédentes,
dans lequel la source de fluide (55) est un compresseur, en particulier un compresseur à siège.

7. Dispositif de refroidissement (10) selon l'une quelconque des revendications précédentes,
dans lequel la source de fluide (55) est disposée dans une partie plus froide du véhicule que le composant (80).

8. Dispositif de refroidissement (10) selon l'une quelconque des revendications précédentes,
dans lequel la source de fluide (55) présente une surpression comprise entre 0,05 et 1,0 bar, en particulier entre 0,1 et 0,3 bar.

9. Dispositif de refroidissement (10) selon l'une quelconque des revendications précédentes,
dans lequel le fluide est un gaz, en particulier de l'air.

10. Dispositif de refroidissement (10) selon l'une quelconque des revendications précédentes,
dans lequel la première plaque (20) présente une conductibilité thermique supérieure à 50 W / (m · K), en particulier supérieure à 200 W / (m · K).

11. Dispositif de refroidissement (10) selon l'une quelconque des revendications précédentes,
dans lequel des matériaux d'interface thermiques sont disposés entre le composant (80) et la première plaque (20).

12. Utilisation d'un dispositif de refroidissement (10) selon l'une quelconque des revendications 1 à 10 pour refroidir une électronique automobile, des modules de caméra, par exemple au niveau du pare-brise, ou des ordinateurs, en particulier des ordinateurs haute performance.

13. Véhicule, comprenant un dispositif de refroidissement (10) selon l'une quelconque des revendications 1 à 10.
